# EUROPÄISCHE PATENTANMELDUNG

(11) **EP 0 963 930 A2**
(43) Veröffentlichungstag der Anmeldung: **15.12.1999**
(21) Anmeldenummer: 99102968.7
(22) Anmeldetag: 13.02.1999
(51) Int. Cl.: B65G 47/90, G11B 23/00, C23C 14/56

(54) **Vorrichtung zum Greifen und Halten eines flachen Substrats**

(30) Priorität: 02.04.1998 DE 19814834
(71) Anmelder: Leybold Systems GmbH, 63450 Hanau (DE)
(72) Erfinder: König, Michael, 60529 Frankfurt am Main (DE); Beul, Johannes, 56479 Rehe (DE); Bangert, Stefan, 36396 Steinau (DE)

(57) **Zusammenfassung**

Bei einer Vorrichtung zum Greifen und Halten einer Compact Disc (14), bestehend aus mehreren, in einem Gehäuse gelagerten mit Magneten (6, ...) versehenen Greifern (5, ...), die in Ausnehmungen (4, ...) des Gehäuses (3) gehalten und geführt sind, die Bewegungen der Greifer (5, ...) quer zur Hochachse (H) des Gehäuses (3) gestatten, und mit einem Elektromagneten (16) zusammenwirken, dessen Magnetfeldachse mit der Hochachse (H) des Gehäuses (3) zusammenfällt und der die Greifer (5, ...) je nach Polung des Elektromagneten (5, ...) zwischen zwei Anschlägen (a, b) hin- und herbewegt, ist das Gehäuse (3) von einem Halter (10) mit Spiel umgriffen, wobei zwischen dem Halter (10) und dem Gehäuse (3) in dem vom Halter (10) umgriffenen Teil (9) des Gehäuses (3) verteilt angeordnete Elemente (13, ...) aus elastischem Werkstoff vorgesehen sind, und weisen die Greifer (5, ...) jeweils zwei Schenkel (5a, 5b, ...) auf, von denen sich jeweils der eine (5a, ...) rechtwinklig zum ersten Schenkel (5b, ...) nach unten zu erstreckt und mit seinem Ende den Rand der zentralen Öffnung (15) des Substrats (14) umgreift.

## Beschreibung

Die Erfindung betrifft eine Vorrichtung zum Greifen und Halten eines flachen, vorzugsweise kreisscheibenförmigen Substrats mit einer zentralen Öffnung, beispielsweise einer Compact Disc, bestehend aus mehreren, in einem Gehäuse gelagerten Greifern, wobei die Greifer in Ausnehmungen des Gehäuses gehalten und geführt sind, die Bewegungen der Greifer quer zur Hochachse des Gehäuses gestatten, wobei an den Enden der Greifer jeweils Magnete fest angeordnet sind, die mit einem zentral im Gehäuse oberhalb der Magnete vorgesehenen Elektromagneten zusammenwirken, dessen Magnetfeldachse mit der Hochachse des Gehäuses zusammenfällt und der die mit Magneten versehenen Greifer je nach Polung des Elektromagneten zwischen zwei Anschlägen hin- und herbewegt.

In der Vakuum-Prozeßtechnik - insbesondere in der Dünnschicht-Technik - ist das Beschichten von kreissscheibenförmigen Substraten, beispielsweise von Glas- oder Aluminiumscheiben für magnetische oder magneto-optische Datenträger bekannt. Diese scheibenförmigen Substrate werden als Speichermedien für digitale Information vielfältig verwendet. In einem Sputterprozeß werden beispielsweise geprägte Kunststoffscheiben mit einer Aluminiumschicht überzogen. Die hierzu eingesetzten Sputter-Beschichtungsanlagen besitzen in aller Regel eine automatisierte Handling-Einrichtung für die Beförderung der Substrate vor, in und hinter einer Vakuum-Kammer.

Von einem Puffer aus transportiert beispielsweise ein Schwenkarm eines Handling-Systems die Substrate in die Vakuum-Kammer. In der Kammer werden dann die Substrate auf einen Drehteller aufgelegt und mit diesem durch die einzelnen Stationen der Vakuum-Kammer hindurchbewegt. Zum Be- und Entladen der Drehteller mit den Substraten sind im Stand der Technik zahlreiche Vorrichtungen zum Greifen und Halten bekannt.

Bisher wurden in den Vakuum-Kammern meist solche Greifer verwendet, die mittels einer Vakuum-Schiebedurchführung von außerhalb der Kammer betätigt werden.

Diese bekannten Vorrichtungen haben den Nachteil, daß sie meist zu viele bewegte Teile enthalten, daß durch die Gleitbewegungen in den Schiebedurchführungen unerwünschte Partikel erzeugt werden, die später in den Beschichtungsraum gelangen und das Beschichtungsergebnis nachteilig beeinflussen. Weiterhin läßt sich bei solchen Schiebedurchführungen in aller Regel nach einer bestimmten Betriebsdauer ein Dichtungsverschleiß feststellen, der immer eine Leckage der Vakuum-Kammer und somit eine zeit- und kostenintensive Reparatur zur Folge hat.

Man hat deshalb bereits eine Vorrichtung vorgeschlagen (G 93 07 263.5) zum Greifen und Halten eines flachen, vorzugsweise scheibenförmigen Substrats, im wesentlichen bestehend aus mehreren fingerförmigen Greifern und einer Membran aus elastischem Material, die eine in einem druckfesten Gehäuse angeordnete Öffnung verschließt, wobei auf der Vorder- und Rückseite der Membran unterschiedliche Drücke einstellbar sind und die Membran so angeordnet ist, daß sie bei anliegender Druckdifferenz eine Auslenkung aus ihrer Ruhelage ausführt und bei Druckgleichheit durch eine Druckfeder wieder in ihre Ruhelage zurückstellbar ist und wobei die Greifer mit ihrem jeweils einen Ende mechanisch mit der Membran so verbunden sind, daß sie mit ihrem anderen, freien Ende eine Schwenkbewegung proportional zur Auslenkung der Membran zum Greifen und Halten, beziehungsweise Freigeben des Substrats ausführen.

Bekannt ist auch (DE 195 29 945 C2) eine Vorrichtung zum Greifen und Halten einer Compact Disc, bestehend aus mehreren fingerförmigen, in einem Gehäuse kippbar gelagerten Greifern, wobei die Greifer in Öffnungen oder Durchbrüchen im Kopfteil des Gehäuses gehalten und geführt sind, die Kippbewegungen der Greifer um Achsen quer zur Längsachse des Gehäuses gestatten, wobei die Kippachsen aller Greifer sich in einer Ebene erstrecken und zusammen ein die Längsachse umschließendes Vieleck bilden, wobei an den dem Substrat abgekehrten Enden der Greifer jeweils Magnete fest angeordnet sind, die mit einem im Gehäuse oberhalb der Magnete vorgesehenen Elektromagneten zusammenwirken, dessen Magnetfeldachse mit der Längsachse des Gehäuses zusammenfällt und der die mit Magneten versehenen Greiferenden je nach Polung des Elektromagneten zwischen zwei Anschlägen hin- und herbewegt.

Aufgabe der vorliegenden Erfindung ist es eine Vorrichtung zu schaffen, die es erlaubt, Substrate inner- und außerhalb von Vakuum-Kammern extrem schnell und besonders zuverlässig zu Greifen und zu Halten. Darüber hinaus soll die Vorrichtung so gehalten und geführt sein, daß sie geringe Ungleichmäßigkeiten und Ungenauigkeiten bei der Zuführung der Substrate ausgleicht und damit Beschädigungen an den empfindlichen Substraten vermeidet.

Diese Aufgabe wird erfindungsgemäß dadurch gelöst, daß das Gehäuse zumindest teilweise von einem Halter mit einer zentralen Öffnung mit Spiel umgriffen ist, wobei zwischen dem Halter und dem Gehäuse in dem vom Halter umgriffenen Teil des Gehäuses verteilt angeordnete Elemente aus elastischem Werkstoff vorgesehen sind, die einerseits mit jeweils ihrer einen Hälfte in einer Vertiefung des Gehäuses und andererseits mit jeweils ihrer anderen Hälfte in einer dieser Vertiefung gegenüberliegenden Vertiefung im Halter ruhen und sich die Ausnehmungen für die Greifer in einer Ebene quer zur Gehäusehochachse und radial nach außen zu erstrecken, wobei die Greifer jeweils zwei Schenkel aufweisen, von denen jeweils der eine einem Gleitschuh bildend in der Ausnehmung gehalten und verschiebbar geführt ist und sich der andere zum ersten Schenkel parallel zur Gehäusehochachse nach unten zu erstreckt und an seinem freien Ende mit einer Einkerbung zum Umgreifen des Randes der zentralen Öffnung des Substrats versehen ist.

Weitere Einzelheiten und Merkmale der Erfindung sind in den Unteransprüchen näher gekennzeichnet und beschrieben.

Die Erfindung läßt die verschiedensten Ausführungsmöglichkeiten zu; eine davon ist in den anhängenden Zeichnungen schematisch dargestellt, die Längsschnitte und die Sicht von unten einer Vorrichtung mit drei radial verschiebbar gelagerten Greifern nach der Erfindung zeigen.

Die Vorrichtung besteht im wesentlichen aus einem flanschförmigen Gehäuse 3 mit einer zentralen Sackloch-Bohrung 4, in die ein kreisscheibenförmiges Führungsteil 5 eingesetzt ist, in das drei sich radial erstreckende Nuten oder Ausnehmungen 4, 4', 4'' eingeschnitten sind.

In den Ausnehmungen 4, ... sind Greifer 5, ... verschiebbar gelagert; wobei jeder Greifer 5, ... zwei Schenkel 5a, 5b aufweist, von denen jeweils einer 5b als Gleitschuh ausgebildet ist und auf seiner oberen Schmalseite mit einem Magneten 6, ... versehen ist. Die Ausnehmungen 4, ... erstrecken sich quer zu der Hochachse H des Gehäuses 3 und zwar in radialer Richtung, wobei im Falle des in den Zeichnungen dargestellten Ausführungsbeispiels insgesamt drei schlitzförmige Ausnehmungen 4, ... unter einem Winkel von jeweils 120° vorgesehen sind. Die Ausnehmungen 4, ... sind in ein kreisscheibenförmiges Teil 7 eingearbeitet, das zusammen mit dem topfförmigen die Magnetspule 16 umschließenden Gehäuseteil 8 im Flansch 9 gehalten sind, wobei das kreisscheibenförmige Teil 7, das topfförmige Teil 8 und der Flansch 9 zusammem das Gehäuse 3 bilden, das von einem Halter 10 umgriffen ist und zwar derart, daß ein Spiel S zwischen Träger 10 und dem Flansch 9 verbleibt. Zwischen dem Flansch 9 und dem Träger 10 sind über den Umfang verteilt im Bereich der Öffnung 17 kugelkalottenförmige Vertiefungen 11, ... vorgesehen, denen jeweils ebensolche kugelförmige Vertiefungen 12, ... im Halter 10 gegenüberliegen. In ein Paar jeweils gegenüberliegenden Vertiefungen 11, 12, .. ist ein kugelartiges Element 13, .... aus elastischem Werkstoff eingelegt, wobei alle Elemente 13, ... zusammen das Gehäuse 3 am Halter 10 arretieren und zwar derart, daß das Gehäuse 3 eine geringe Schwenk- bzw. Kippbewegung gegenüber dem Halter 10 ausführen kann.

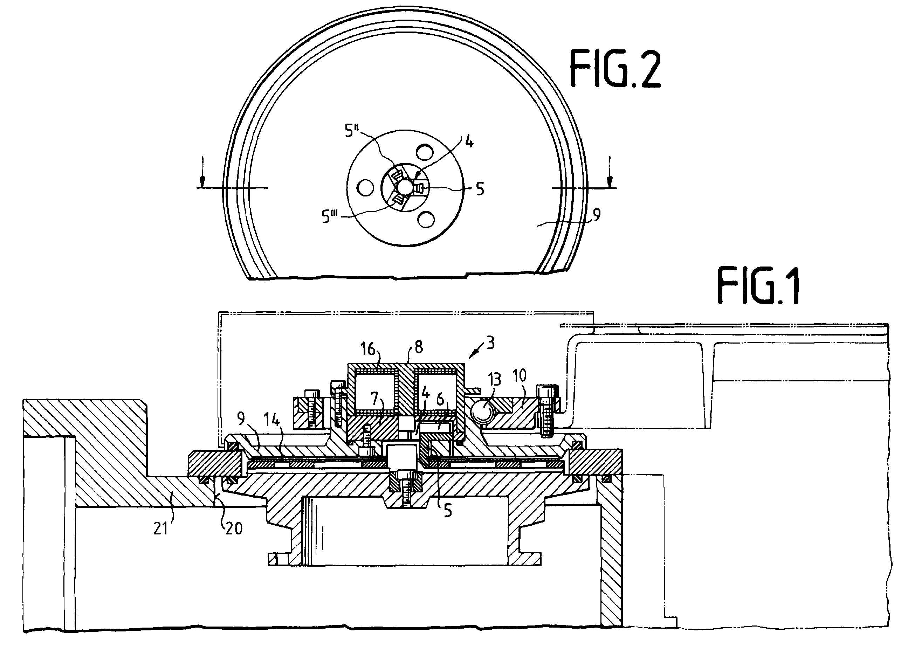

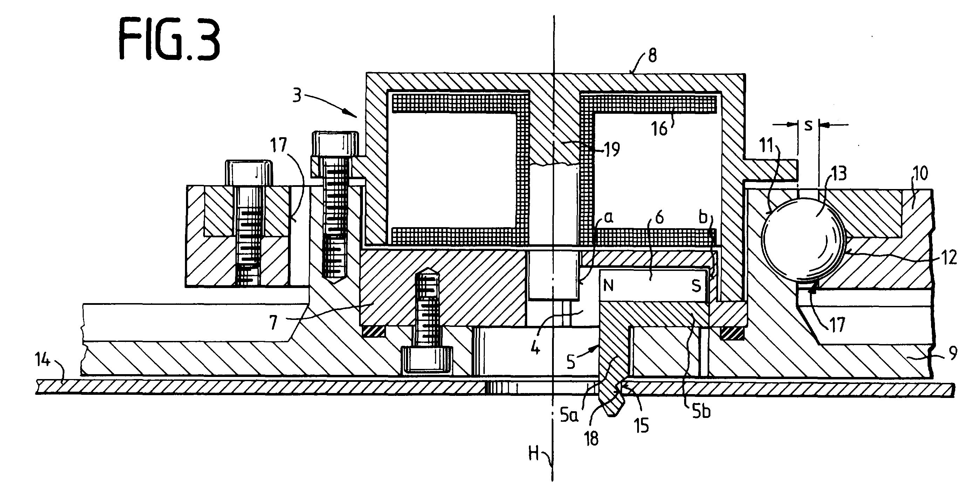

Im topfförmigen Teil 8 des Gehäuses 3, das ein Magnetjoch bildet, ist eine Magnetspule 16 angeordnet und auf den sich lotrecht erstreckenden Zapfen 19 aufgeschoben, wobei der Zapfen 19 einen Anschlag a bildet, an dem die drei Greifer 5, 5', ... anliegen, wenn die Vorrichtung sich in Lösestellung befindet. In Fig. 3, die einen Ausschnitt der Darstellung gemäß Fig. 1, jedoch in vergrößertem Maßstab zeigt, befinden sich die Greifer 5, .... in der Spannstellung, wobei die lotrechten Schenkel 5 a, ... bzw. deren Kerben 18, ... den Rand der zentralen Öffnung 15 des Substrats 14 bzw. der CD umschließen, so daß diese vom Arm 10 der Transporteinrichtung angehoben und transportiert werden kann. In der Spannstellung liegen die Stabmagneten 6, ..., die jeweils mit dem sich horizontal erstreckenden Schenkel 5 b, ... fest verbunden sind am Anschlag b an.

Wie Fig. 1 zeigt, bildet das Gehäuse 3 mit dem Flansch 9 eine Vakuumschleuse, indem der Flansch 9 die Öffnung 20 in der Vakuumkammerwand 22 verschließt bzw. diese Öffnung 20 freigibt. Die Greifer 5, ... befinden sich in der Verschlußstellung im Vakuumbereich während die Magnetspule 16 auf der Atmosphärenseite bleibt.

## Patentansprüche

1. Vorrichtung zum Greifen und Halten eines flachen, vorzugsweise kreisscheibenförmigen Substrats (14) mit einer zentralen Öffnung (15), beispielsweise einer Compact Disc, bestehend aus mehreren, in einem Gehäuse gelagerten Greifern (5, ...), wobei die Greifer (5, ...) in Ausnehmungen (4, ...) des Gehäuses (3) gehalten und geführt sind, die Bewegungen der Greifer (5, ...) quer zur Hochachse (H) des Gehäuses (3) gestatten, wobei an den Greifern (5, ...) jeweils Magnete (6, ...) fest angeordnet sind, die mit einem zentral im Gehäuse (3) oberhalb der Magnete (6) vorgesehenen Elektromagneten (16) zusammenwirken, dessen Magnetfeldachse mit der Hochachse (H) des Gehäuses (3) zusammenfällt und der die mit Magneten (6, ...) versehenen Greifer (5, ...) je nach Polung des Elektromagneten (5, ...) zwischen zwei Anschlägen (a, b) hin- und herbewegt, **dadurch gekennzeichnet**, daß das Gehäuse (3) zumindest teilweise von einem Halter (10) mit einer zentralen Öffnung (17) mit Spiel umgriffen ist, wobei zwischen dem Halter (10) und dem Gehäuse (3) in dem vom Halter (10) umgriffenen Teil (9) des Gehäuses (3) verteilt angeordnete Elemente (13, ...) aus elastischem Werkstoff vorgesehen sind, die einerseits mit jeweils ihrer einen Hälfte in einer Vertiefung (11, ...) des Gehäuseteiles (9) und andererseits mit jeweils ihrer anderen Hälfte in einer dieser Vertiefung (11, ...) gegenüberliegenden Vertiefung (12, ...) im Halter (10) ruhen und sich die Ausnehmungen (4, ...) für die Greifer (5, ...) in einer Ebene quer zur Gehäusehochachse (H) und radial nach außen zu erstrecken, wobei die Greifer (5, ...)jeweils zwei Schenkel (5a, 5b, ...) aufweisen, von denen jeweils der eine (5b, ...) einen Gleitschuh bildend in der Ausnehmung (4) gehalten und radial verschiebbar geführt ist und sich der andere (5a, ...) rechtwinklig zum ersten Schenkel (5b, ...) und parallel zur Gehäusehochachse (H) nach unten zu erstreckt und an seinem freien Ende mit einer Einkerbung (18, ...) zum Umgreifen des Randes der zentralen Öffnung (15) des Substrats (14) versehen ist.

2. Vorrichtung zum Greifen und Halten eines flachen, vorzugsweise kreisscheibenförmigen Substrats (14) mit einer zentralen Öffnung (15), beispielsweise einer Compact Disc, bestehend aus mehreren, in einem Gehäuse gelagerten Greifern (5, ...), wobei die Greifer (5, ...) in Ausnehmungen (4, ...) des Gehäuses (3) gehalten und geführt sind, die Bewegungen der Greifer (5, ...) quer zur Hochachse (H) des Gehäuses (3) gestatten, wobei an den Greifern (5, ...) jeweils Magnete (6, ...) fest angeordnet sind, die mit einem zentral im Gehäuse (3) oberhalb der Magnete (6) vorgesehenen Elektromagneten (16) zusammenwirken, dessen Magnetfeldachse mit der Hochachse (H) des Gehäuses (3) zusammenfällt und der die mit Magneten (6, ...) versehenen Greifer (5, ...) je nach Polung des Elektromagneten (5, ...) zwischen zwei Anschlägen (a, b) hin- und herbewegt, **dadurch gekennzeichnet**, daß das Gehäuse (3) zumindest teilweise von einem Halter (10) mit einer zentralen Öffnung (17) mit Spiel umgriffen ist, wobei zwischen dem Halter (10) und dem Gehäuse (3) in dem vom Halter (10) umgriffenen Teil (9) des Gehäuses (3) verteilt angeordnete Elemente (13, ...) aus elastischem Werkstoff vorgesehen sind, die einerseits mit jeweils ihrer einen Hälfte in einer Vertiefung (11, ...) des Gehäuseteiles (9) und andererseits mit jeweils ihrer anderen Hälfte in einer dieser Vertiefung (11, ...) gegenüberliegenden Vertiefung (12, ...) im Halter (10) ruhen.

3. Vorrichtung zum Greifen und Halten eines flachen, vorzugsweise kreisscheibenförmigen Substrats (14) mit einer zentralen Öffnung (15), beispielsweise einer Compact Disc, bestehend aus mehreren, in einem Gehäuse gelagerten Greifern (5, ...), wobei die Greifer (5, ...) in Ausnehmungen (4, ...) des Gehäuses (3) gehalten und geführt sind, die Bewegungen der Greifer (5, ...) quer zur Hochachse (H) des Gehäuses (3) gestatten, wobei an den Greifern (5, ...) jeweils Magnete (6, ...) fest angeordnet sind, die mit einem zentral im Gehäuse (3) oberhalb der Magnete (6) vorgesehenen Elektromagneten (16) zusammenwirken, dessen Magnetfeldachse mit der Hochachse (H) des Gehäuses (3) zusammenfällt und der die mit Magneten (6, ...) versehenen Greifer (5, ...) je nach Polung des Elektromagneten (5, ...) zwischen zwei Anschlägen (a, b) hin- und herbewegt, **dadurch gekennzeichnet**, sich die Ausnehmungen (4, ...) für die Greifer (5, ...) in einer Ebene quer zur Gehäusehochachse (H) und radial nach außen zu erstrecken, wobei die Greifer (5, ...) jeweils zwei Schenkel (5a, 5b, ...) aufweisen, von denen jeweils der eine (5b, ...) einen Gleitschuh bildend in der Ausnehmung (4) gehalten und radial verschiebbar geführt ist und sich der andere (5a, ...) rechtwinklig zum ersten Schenkel (5b, ...) und parallel zur Gehäusehochachse (H) nach unten zu erstreckt und an seinem freien Ende mit einer Einkerbung (18, ...) zum Umgreifen des Randes der zentralen Öffnung (15) des Substrats (14) versehen ist.
